# EUROPEAN PATENT SPECIFICATION

(11) **EP 4 531 255 B1**
(45) Date of publication and mention of the grant of the patent: **08.07.2026**
(21) Application number: 24192146.9
(22) Date of filing: 31.07.2024
(51) Int. Cl.: H02M 1/32, H02M 1/36

(54) **FAULT DETECTION METHOD AND FAULT PROTECTION METHOD FOR POWER CONVERSION SYSTEM, AND POWER CONVERSION SYSTEM**
FEHLERERKENNUNGSVERFAHREN UND FEHLERSCHUTZVERFAHREN FÜR EIN STROMWANDLUNGSSYSTEM UND STROMWANDLUNGSSYSTEM
PROCÉDÉ DE DÉTECTION DE DÉFAILLANCE ET PROCÉDÉ DE PROTECTION DE DÉFAILLANCE POUR SYSTÈME DE CONVERSION DE PUISSANCE, ET SYSTÈME DE CONVERSION DE PUISSANCE

(30) Priority: 26.09.2023 CN 202311259348
(43) Date of publication of application: 02.04.2025
(73) Proprietor: Sungrow Power Supply Co., Ltd., Hefei, Anhui 230088 (CN)
(72) Inventor: ZHENG, Feiyang, Hefei, Anhui (CN); DENG, Kai, Hefei, Anhui (CN); LI, Le, Hefei, Anhui (CN)
(74) Representative: Zacco Norway AS

(56) References cited:
- WO-A1-2017/033411
- WO-A1-2017/204938
- US-A1- 2015 185 271
- US-A1- 2023 291 303

## Description

### FIELD

The present disclosure relates to the technical field of fault detection for circuits, and in particular to a fault detection method and a fault protection method for a power conversion system, and a power conversion system.

### BACKGROUND

At present, an alternating current pre-charge power supply is used to enable a power conversion system to operate in a reactive mode without consuming energy of a battery rack. That is, when the power conversion system operates in the reactive mode, the battery rack does not operate in relevant circuits. In such case, when a bus capacitor of the power conversion system is short-circuited, there is short-circuit current flowing through a circuit where the bus capacitor and the alternating current pre-charge power supply are arranged. The alternating current pre-charge power supply is prone to be damaged by the short-circuit current. As an example, patent document with publication no. WO 2017/033411 A1 discloses a power supply device for surely detecting abnormality of a capacitor connected in parallel with a load, in which the power supply device includes a battery, an output switch, a pre-charging circuit and an abnormality detecting circuit, and the abnormality detecting circuit detects abnormality of the capacitor or the connection circuit thereof based on the voltage increase characteristic of the capacitor that is pre-charged by the pre-charging circuit. As another example, patent document with publication no. WO 2017/204938 A1 discloses a system and method for intelligent circuit breaking in adjustable speed drives. As another example, patent document with publication no. US 2023/291303 A1, discloses a power converter for transferring power between an AC side and a DC side, and power supply method. As another example, patent document with publication no. US 2015/185271 A1 discloses a method and system of diagnosing breakdown during pre-charging.

How to perform further fault detection on the power conversion system is a technical problem to be solved urgently.

### SUMMARY

In order to solve the problem that it is difficult to perform fault detection on a power conversion system in the conventional technology, a fault detection method and a fault protection method for a power conversion system, and a power conversion system are provided according to the present disclosure.

The following technical solutions are provided according to the present disclosure.

A fault detection method for a power conversion system is provided in accordance with claim 1.

A power conversion system is further provided in accordance with claim 9.

The above technical solutions according to the present disclosure have the following beneficial effects.

When the power conversion system operates in a reactive mode, the alternating current pre-charge power supply is controlled to charge the bus capacitor of the power conversion system, and the bus capacitor supplies power to the DSP through the first SPS. When the bus capacitor is short-circuited, the bus capacitor is equivalent to a wire. In such case, current flows from the positive electrode of the output end of the alternating current pre-charge power supply to the negative electrode of the output end of the alternating current pre-charge power supply through the bus capacitor, rather than flowing to the DSP 12, that is, the circuit where the bus capacitor and the alternating current pre-charge power supply are arranged is short-circuited. Therefore, the DSP is de-energized.

### BRIEF DESCRIPTION OF THE DRAWINGS

In order to more clearly illustrate technical solutions in embodiments of the present disclosure or in the conventional technology, drawings to be used in the description of the embodiments or the conventional technology are briefly described hereinafter. It is apparent that the drawings described below show only the embodiments of the present disclosure, and other drawings may be obtained by those skilled in the art from the drawings without any creative work.
Figure 1 is a schematic diagram of a circuit structure of a power conversion system according to an embodiment of the present disclosure;
Figure 2 is a flowchart of a fault detection method for a power conversion system according to a comparative example of the present disclosure;
Figure 3 is a flowchart of a fault detection method for a power conversion system according to another comparative example of the present disclosure;
Figure 4 is a flowchart of a fault detection method for a power conversion system according to a first claimed embodiment of the present disclosure; and
Figure 5 is a flowchart of a fault detection method for a power conversion system according to another claimed embodiment of the present disclosure.

### DETAILED DESCRIPTION OF EMBODIMENTS

At present, an alternating current pre-charge power supply is used to enable a power conversion system to operate in a reactive mode without consuming energy of a battery rack. That is, when the power conversion system operates in the reactive mode, the battery rack does not operate in relevant circuits. In such case, when a bus capacitor of the power conversion system is short-circuited, there is short-circuit current flowing through a circuit where the bus capacitor and the alternating current pre-charge power supply are arranged. The alternating current pre-charge power supply is prone to be damaged by the short-circuit current. In addition, when the bus capacitor is short-circuited, the power conversion system fails to operate normally.

A fault detection method and a fault protection method for a power conversion system, and a power conversion system are provided according to the present disclosure, in order to detect a short-circuit fault of the bus capacitor when the bus capacitor of the power conversion system is short-circuited, so as to perform fault protection and fault handling based on a fault detection result, thereby preventing the alternating current pre-charge power supply from being damaged by the short-circuit current generated due to the short-circuit fault of the bus capacitor, and avoiding affecting the normal operation of the power conversion system by the short-circuit fault of the bus capacitor.

The technical solutions according to the present disclosure are described in detail below in conjunction with the drawings.

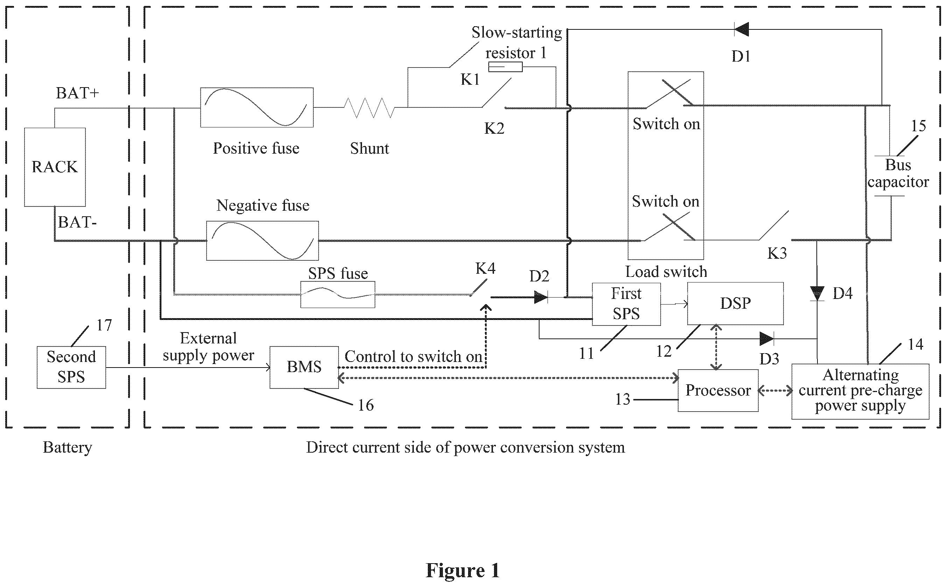

Figure 1 is a schematic diagram of a circuit structure of a power conversion system according to an embodiment of the present disclosure. As shown in Figure 1, the power conversion system includes a main circuit, a first SPS 11, a DSP 12, a processor 13 and an alternating current pre-charge power supply 14.

A bus capacitor 15 is connected between a positive electrode and a negative electrode of a battery side of the main circuit, and the bus capacitor 15 is connected to an input end of the first SPS 11. The first SPS 11 is configured to supply power to the DSP 12.

An output end of the alternating current pre-charge power supply 14 is connected to the bus capacitor 15, and the alternating current pre-charge power supply 14 is controlled by the processor 13.

The processor 13 is communicatively connected to the DSP 12 and a BMS 16. The processor 13 is configured to control a first preset power supply through the BMS 16 to supply power to the first SPS 11, and perform the fault detection method for a power conversion system according to the present disclosure, to implement fault detection on the power conversion system.

In the embodiment of the present disclosure, the main circuit is provided with main functional components of the power conversion system. A direct current side, namely the battery side, of the main circuit is configured to connect a battery. In practice, a positive fuse, a negative fuse, a shunt, a main contactor K2, a main contactor K3, a slow-starting contactor K1, a slow-starting resistor, a load switch and the like that are shown in Figure 1 are connected between the battery and the battery side of the main circuit. In a case that the main circuit is a bidirectional DC-AC conversion circuit, an alternating current side of the main circuit is configured to connect a power grid and/or a load. In a case that the main circuit is a bidirectional DC-DC conversion circuit, the other direct current side of the main circuit is configured to connect to a direct current bus of a photovoltaic inverter. The first SPS 11 is a direct current power supply and is implemented as a DC-DC conversion circuit. The processor 13 is an Advanced RISC Machine (ARM) processor.

The processor 13 controls the alternating current pre-charge power supply 14 to charge the bus capacitor 15. Since the bus capacitor 15 is connected to the input end of the first SPS 11, the bus capacitor 15 supplies power to the DSP 12 through the first SPS 11 after the bus capacitor 15 is charged. The processor 13 further sends a control instruction to the BMS 16, so that the BMS 16 switches on an auxiliary contactor K4 in response to the control instruction. After the auxiliary contactor K4 is switched on, the first preset power supply supplies power to the first SPS 11, so that the first SPS 11 supplies power to the DSP 12. The first preset power supply is shown as RACK in Figure 1. The BMS 16 is further configured to implement information interaction between the processor 13 and a user.

In the embodiment of the present disclosure, the BMS 16 is powered by an external second SPS 17 and supplies power to the processor 13. In addition, the BMS 16 exchanges information with the processor 13.

In practice, a positive electrode of the bus capacitor 15 is connected to a positive electrode of the input end of the first SPS 11 through a first diode D1, and the first preset power supply supplies power to the first SPS 11 through a second diode D2, to ensure a direction in which current flows through the positive electrode of the input end of the first SPS 11, preventing current from flowing from a power supply with a high voltage among the bus capacitor 15 and the first preset power supply to the other power supply with a low voltage, i.e., current backflow, resulted from that the bus capacitor 15 and the first preset power supply are connected to the input end of the first SPS 11, thereby preventing the power supply to which backflow current flows from being damaged.

Based on a same principle, in the embodiment of the present disclosure, a negative electrode of the input end of the first SPS 11 is connected to a negative electrode of the output end of the alternating current pre-charge power supply 14 through a third diode D3, and a negative electrode of the bus capacitor 15 is connected to the negative electrode of the output end of the alternating current pre-charge power supply 14 through a fourth diode D4, avoiding a problem of a direction in which a current flows resulted from that both the negative electrode of the input end of the first SPS 11 and the negative electrode of the bus capacitor 15 are connected to the negative electrode of the output end of the alternating current pre-charge power supply 14, thereby avoiding current backflow.

Based on a same concept, a fault detection method for a power conversion system is further provided according to the present disclosure. The fault detection method is applied to the processor 13.

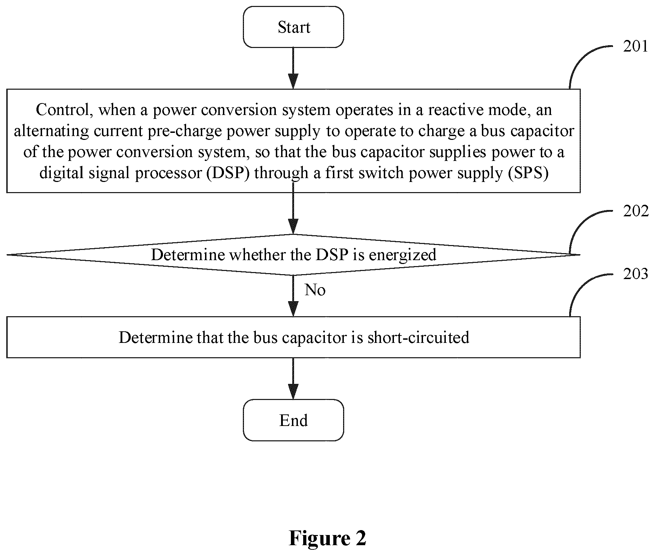

Figure 2 is a flowchart of a fault detection method for a power conversion system according to a comparative example of the present disclosure. As shown in Figure 2, the fault detection method for a power conversion system includes the following steps 201 to 203.

In step 201, when the power conversion system operates in a reactive mode, the alternating current pre-charge power supply is controlled to operate to charge the bus capacitor of the power conversion system, so that the bus capacitor supplies power to the DSP through the first SPS.

In the comparative example of the present disclosure, when the power conversion system operates in the reactive mode, the power conversion system functions as a reactive power compensation device for a power grid system.

In step 202, it is determined whether the DSP is energized to obtain a first determination result. The process proceeds to step 203 if the first determination result indicates that the DSP is de-energized.

In the comparative example of the present disclosure, referring to Figure 1, the processor 13 is communicatively connected to the DSP 12 when the DSP 12 is energized, and the processor 13 fails to be communicatively connected to the DSP 12 when the DSP 12 is de-energized. Therefore, in step 202, it is determining whether the DSP is energized by: determining whether the DSP is communicatively connected to the processor 13; determining that the DSP is energized, in a case of determining that the DSP is communicatively connected to the processor 13; and determining that the DSP is de-energized, in a case of determining that the DSP fails to be communicatively connected to the processor 13.

In step 203, it is determined that the bus capacitor is short-circuited.

The above technical solutions are provided according to the comparative of the present disclosure. Referring to Figure 1, when the bus capacitor 15 is short-circuited, the bus capacitor 15 is equivalent to a wire. In such case, current flows from the positive electrode of the output end of the alternating current pre-charge power supply 14 to the negative electrode of the output end of the alternating current pre-charge power supply 14 through the bus capacitor 15 and the fourth diode D4, rather than flowing to the DSP 12 through the first diode D1 and the first SPS 11. Therefore, the DSP is de-energized.

Based on such principle, in the comparative of the present disclosure, when the power conversion system operates in the reactive mode, the alternating current pre-charge power supply is controlled to operate to charge the bus capacitor of the power conversion system, so that the bus capacitor supplies power to the DSP through the first SPS. It is determined whether the DSP is energized to obtain the first determination result. If the first determination result indicates that the DSP is de-energized, it is determined that the bus capacitor is short-circuited. In this way, according to the comparative example of the present disclosure, when the bus capacitor of the power conversion system is short-circuited, the short-circuit fault of the bus capacitor can be detected, so as to perform fault protection based on a fault detection result, thereby preventing the alternating current pre-charge power supply from being damaged by the short-circuit current generated due to the short-circuit fault of the bus capacitor and improving the reliability of the power conversion system.

Moreover, when the DSP is de-energized, the power conversion system fails to start and therefore fails to operate normally. In the comparative example of the present disclosure, when the bus capacitor of the power conversion system is short-circuited, the short-circuit fault of the bus capacitor can be detected, so as to perform fault protection based on a fault detection result, thereby avoiding affecting the normal operation of the power conversion system by the short-circuit fault of the bus capacitor.

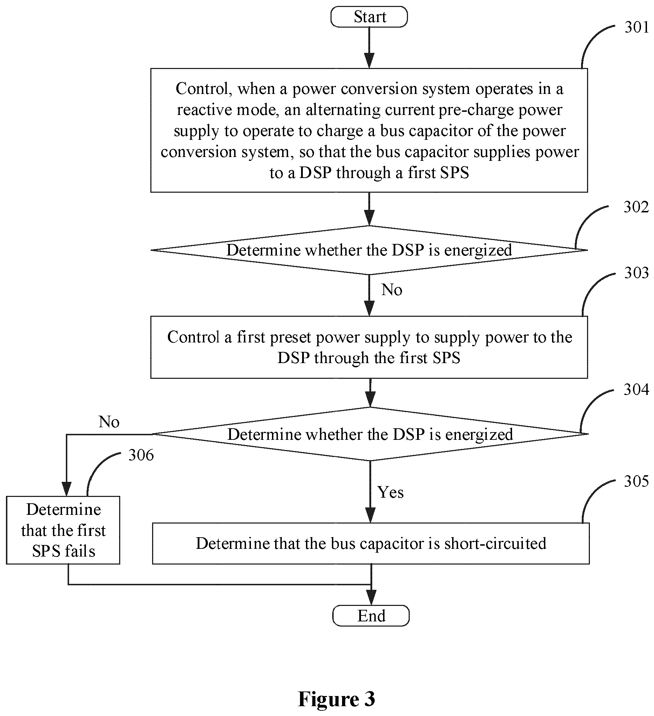

Figure 3 is a flowchart of a fault detection method for a power conversion system according to another comparative example of the present disclosure. As shown in Figure 3, the fault detection method for a power conversion system includes the following steps 301 to 306.

In step 301, when the power conversion system operates in a reactive mode, the alternating current pre-charge power supply is controlled to operate to charge the bus capacitor of the power conversion system, so that the bus capacitor supplies power to the DSP through the first SPS.

In step 302, it is determined whether the DSP is energized to obtain a first determination result. The process proceeds to step 303 if the first determination result indicates that the DSP is de-energized.

In step 303, the first preset power supply is controlled to supply power to the DSP through the first SPS.

In the another comparative example of the present disclosure, referring to Figure 1, in a case that the first preset power supply is shown as RACK in Figure 1, the processor 13 sends a control instruction to the BMS 16, so that the BMS 16 switches on the auxiliary contactor K4 in response to the control instruction. After the auxiliary contactor K4 is switched on, the first preset power supply supplies power to the first SPS 11, so that the first SPS 11 supplies power to the DSP 12.

In step 304, it is re-determined whether the DSP is energized to obtain a second determination result. The process proceeds to step 305 if the second determination result indicates that the DSP is energized, and the process proceeds to step 306 if the second determination result indicates that the DSP is de-energized.

In step 305, it is determined that the bus capacitor is short-circuited.

In step 306, it is determined that the first SPS fails.

The above technical solutions are provided according to the another comparative example of the present disclosure. After the alternating current pre-charge power supply 14 is controlled to charge the bus capacitor 15 to cause the bus capacitor 15 to supply power to the DSP 12 through the first SPS 11, the first preset power supply is controlled to supply power to the DSP 12 through the first SPS 11 if the DSP 12 is de-energized. That is, the first preset power supply, instead of the bus capacitor 15, supplies power to the DSP 12 through the first SPS 11. In such case, if the DSP 12 is energized, it indicates that the first SPS 11 does not fail, and then it is determined that the bus capacitor is short-circuited; and if the DSP 12 is de-energized, it indicates that the first SPS 11 fails.

In this way, according to the another comparative example of the present disclosure, in a case that the first SPS 11 fails or the bus capacitor 15 is short-circuited, the fault can be located, which improves the accuracy of the fault detection result and is convenient for maintenance personnel to accurately maintain the power conversion system based on the fault detection result, thereby improving the efficiency of maintenance.

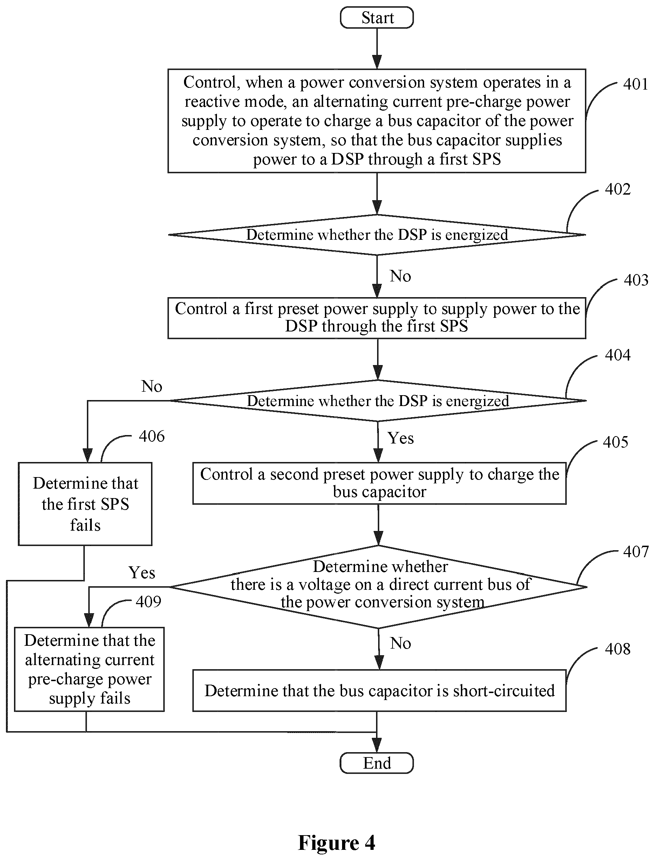

Figure 4 is a flowchart of a fault detection method for a power conversion system according to the claimed embodiment of the present disclosure. As shown in Figure 4, the fault detection method for a power conversion system includes the following steps 401 to 409.

In step 401, when the power conversion system operates in a reactive mode, the alternating current pre-charge power supply is controlled to operate to charge the bus capacitor of the power conversion system, so that the bus capacitor supplies power to the DSP through the first SPS.

In step 402, it is determined whether the DSP is energized to obtain a first determination result. The process proceeds to step 403 if the first determination result indicates that the DSP is de-energized.

In step 403, the first preset power supply is controlled to supply power to the DSP through the first SPS.

In step 404, it is re-determined whether the DSP is energized to obtain a second determination result. The process proceeds to step 405 if the second determination result indicates that the DSP is energized, and the process proceeds to step 406 if the second determination result indicates that the DSP is de-energized.

In step 405, a second preset power supply is controlled to charge the bus capacitor.

In the embodiment of the present disclosure, referring to Figure 1, the second preset power supply is shown as RACK in Figure 1. For controlling the second preset power supply to charge the bus capacitor 15, the processor 13 switches on the slow-starting contactor K1 and the main contactor K3, so that the second preset power supply RACK charges the bus capacitor 15.

In step 406, it is determined that the first SPS fails.

In step 407, it is determined whether there is a voltage on a direct current bus of the power conversion system to obtain a third determination result. The process proceeds to step 408 if the third determination result indicates that there is no voltage on the direct current bus, and the process proceeds to step 409 if the third determination result indicates that there is a voltage on the direct current bus.

In step 408, it is determined that the bus capacitor is short-circuited.

In step 409, it is determined that the alternating current pre-charge power supply fails.

The above technical solutions are provided according to the claimed embodiment of the present disclosure. Compared with the fault detection method shown in Figure 3, in the fault detection method according to this embodiment, if the second determination result indicates that the DSP is energized (that is, the first SPS does not fail), the second preset power supply is controlled to charge the bus capacitor (that is, the second preset power supply, instead of the alternating current pre-charge power supply, charges the bus capacitor). In such case, if there is a voltage on the direct current bus, it indicates that the bus capacitor is not short-circuited (when the bus capacitor is short-circuited, there is no voltage on the direct current bus), and then it is determined that the alternating current pre-charge power supply fails. If there is no voltage on the direct current bus, it is determined that the bus capacitor is short-circuited.

In this way, according to the claimed embodiment of the present disclosure, in a case that the first SPS 11 fails, the bus capacitor 15 is short-circuited, or the alternating current pre-charge power supply 14 fails, the fault can be located, which further improves the accuracy of the fault detection result and is convenient for maintenance personnel to accurately maintain the power conversion system based on the detection result, thereby improving the efficiency of maintenance.

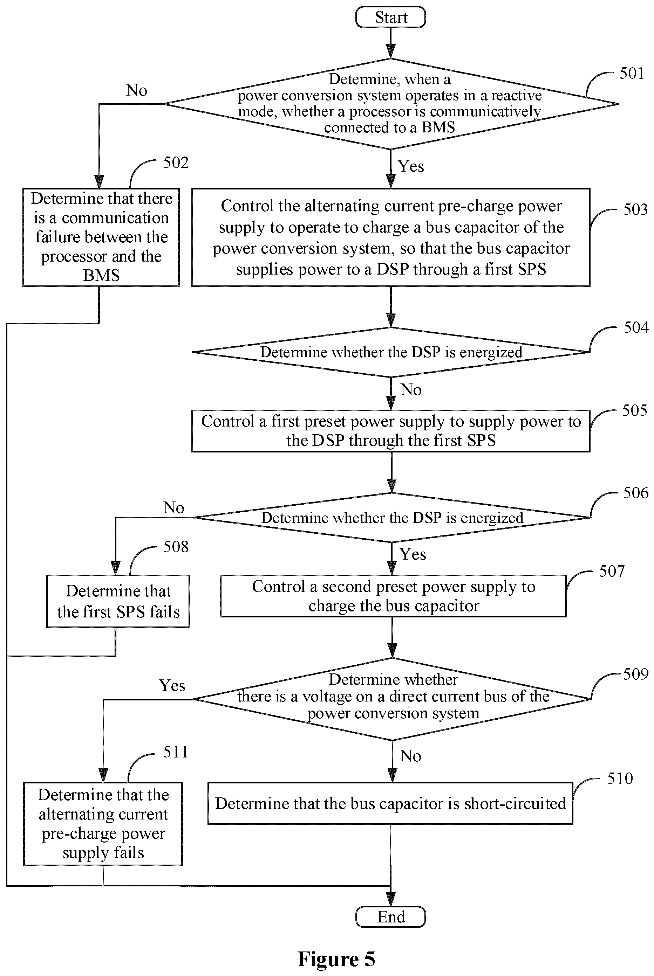

Figure 5 is a flowchart of a fault detection method for a power conversion system according to another claimed embodiment of the present disclosure. As shown in Figure 5, the fault detection method for a power conversion system includes the following steps 501 to 511.

In step 501, when the power conversion system operates in a reactive mode, it is determined whether the processor of the power conversion system is communicatively connected to a BMS. The process proceeds to step 503 in a case of determining that the processor is communicatively connected to the BMS, and the process proceeds to step 502 in a case of determining that the processor fails to be communicatively connected to the BMS.

In the another claimed embodiment of the present disclosure, it can be seen from the above descriptions that the processor controls the first preset power supply through the BMS to supply power to the first SPS, so that the first SPS supplies power to the DSP. Moreover, the BMS implements information interaction between the processor and the user. For example, the user sends a fault detection instruction to the BMS. On receipt of the fault detection instruction, the BMS sends the fault detection instruction to the processor. The processor performs the fault detection method for a power conversion system according to the present disclosure in response to the fault detection instruction.

Therefore, it is determined in advance whether the processor is communicatively connected to the BMS and subsequent steps are performed after the processor is communicatively connected to the BMS, which is conducive to successfully performing the fault detection method, thereby improving a success rate of the fault detection and facilitating the user to intervene in the fault detection process.

It should be noted that in the fault detection methods for a power conversion system shown in Figure 2, Figure 3 and Figure 4, it is determined in advance whether the processor is communicatively connected to the BMS before the alternating current pre-charge power supply is controlled to operate, and the subsequent steps are performed after the processor is communicatively connected to the BMS. In a case of determining that the processor fails to be communicatively connected to the BMS, it is directly determined that there is a communication failure between the processor and the BMS, and the fault detection process ends.

In step 502, it is determined that there is a communication failure between the processor and the BMS.

In step 503, the alternating current pre-charge power supply is controlled to operate to charge the bus capacitor of the power conversion system, so that the bus capacitor supplies power to the DSP through the first SPS.

In step 504, it is determined whether the DSP is energized to obtain a first determination result. The process proceeds to step 505 if the first determination result indicates that the DSP is de-energized.

In step 505, the first preset power supply is controlled to supply power to the DSP through the first SPS.

In step 506, it is re-determined whether the DSP is energized to obtain a second determination result. The process proceeds to step 507 if the second determination result indicates that the DSP is energized, and the process proceeds to step 508 if the second determination result indicates that the DSP is de-energized.

In step 507, the second preset power supply is controlled to charge the bus capacitor.

In step 508, it is determined that the first SPS fails.

In step 509, it is determined whether there is a voltage on the direct current bus of the power conversion system to obtain a third determination result. The process proceeds to step 510 if the third determination result indicates that there is no voltage on the direct current bus, and the process proceeds to step 511 if the third determination result indicates that there is a voltage on the direct current bus.

In step 510, it is determined that the bus capacitor is short-circuited.

In step 511, it is determined that the alternating current pre-charge power supply fails.

In the another claimed embodiment of the present disclosure, before step 501 of determining whether the processor of the power conversion system is communicatively connected to the BMS, the fault detection method for a power conversion system further includes as follows.

It is determined whether the power conversion system operates in the reactive mode. When the power conversion system operates in the reactive mode, the process proceeds to step 501 of determining whether the processor of the power conversion system is communicatively connected to the BMS. When the power conversion system does not operate in the reactive mode, the power conversion system is controlled to operate in the reactive mode, and then the process proceeds to step 501 of determining whether the processor of the power conversion system is communicatively connected to the BMS.

In the another claimed embodiment of the present disclosure, after step 504 of determining whether the DSP is energized to obtain a first determination result, the fault detection method for a power conversion system further includes: controlling the power conversion system to operate normally if the first determination result indicates that the DSP is energized.

It should be noted that this solution is also applicable to the fault detection methods for a power conversion system shown in Figure 2, Figure 3 and Figure 4.

Based on a general concept, a fault protection method for a power conversion system is further provided according to the present disclosure. The fault protection method for a power conversion system includes: controlling, during fault detection on the power conversion system with the fault detection method for a power conversion system according to the above embodiments of the present disclosure, the alternating current pre-charge power supply to stop operating when it is determined that the DSP is de-energized for a first time.

In a first fault protection method of the present disclosure, after it is determined whether the DSP is energized for the first time to obtain the first determination result, the alternating current pre-charge power supply is controlled to stop operating if the first determination result indicates that the DSP is de-energized, preventing the alternating current pre-charge power supply from being damaged by short-circuit current generated due to the short-circuit fault of the bus capacitor.

In a second fault protection method of the present disclosure, the fault protection method for a power conversion system further includes: controlling the power conversion system to stop operating when it is determined that the bus capacitor of the power conversion system is short-circuited, when it is determined that the alternating current pre-charge power supply fails, or when it is determined that the first SPS fails.

In the the fault protection methods of the present disclosure, the power conversion system is controlled to stop operating after the fault is located, preventing the power conversion system from being damaged, so that the maintenance personnel can perform fault handling on the power conversion system.

## Claims

1. A fault detection method for a power conversion system, comprising:
controlling (401, 503) when the power conversion system operates in a reactive mode, an alternating current pre-charge power supply to operate to charge a bus capacitor connected to a direct current bus of the power conversion system, wherein the bus capacitor is configured to supply power to a digital signal processor, DSP, through a first switch power supply, SPS;
determining (402, 504) whether the DSP is energized to obtain a first determination result;
controlling (403, 505) a first preset power supply to supply power to the DSP through the first SPS, if the first determination result indicates that the DSP is de-energized;
re-determining (404, 506) whether the DSP is energized to obtain a second determination result;
controlling (405, 507) a second preset power supply to charge the bus capacitor, if the second determination result indicates that the DSP is energized;
determining (407, 509) whether there is a voltage on the direct current bus to obtain a third determination result; and
determining (408, 510) that the bus capacitor is short-circuited, if the third determination result indicates that there is no voltage on the direct current bus.

2. The fault detection method for a power conversion system according to claim 1, further comprising:
determining (406, 508) that the first SPS fails, if the second determination result indicates that the DSP is de-energized.

3. The fault detection method for a power conversion system according to claim 1, further comprising:
determining (409, 511) that the alternating current pre-charge power supply fails, if the third determination result indicates that there is a voltage on the direct current bus.

4. The fault detection method for a power conversion system according to any one of claims 1 to 3, wherein before the controlling an alternating current pre-charge power supply to operate, the method further comprises:
determining (501) whether a processor of the power conversion system is communicatively connected to a battery management system, BMS; and
controlling (503) the alternating current pre-charge power supply to operate, in a case of determining that the processor is communicatively connected to the BMS.

5. The fault detection method for a power conversion system according to claim 4, wherein after the determining whether a processor of the power conversion system is communicatively connected to a BMS, the method further comprises:
determining (502) that there is a communication failure between the processor and the BMS, in a case of determining that the processor fails to be communicatively connected to the BMS.

6. The fault detection method for a power conversion system according to any one of claims 1 to 3, wherein the determining whether the DSP is energized comprises:
determining whether the DSP is communicatively connected to a processor of the power conversion system;
determining that the DSP is energized, in a case of determining that the DSP is communicatively connected to the processor of the power conversion system; and
determining that the DSP is de-energized, in a case of determining that the DSP fails to be communicatively connected to the processor of the power conversion system.

7. A fault protection method for a power conversion system, comprising:
controlling, during fault detection on the power conversion system with the fault detection method for a power conversion system according to any one of claims 1 to 6, the alternating current pre-charge power supply to stop operating when it is determined that the DSP is de-energized for a first time.

8. The fault protection method for a power conversion system according to claim 7, further comprising:
controlling the power conversion system to stop operating when it is determined that the bus capacitor of the power conversion system is short-circuited, when it is determined that the alternating current pre-charge power supply fails, or when it is determined that the first SPS fails.

9. A power conversion system, comprising:
a digital signal processor, DSP (12);
a first switch power supply, SPS, (11) configured to supply power to the DSP (12);
a battery management system, BMS (16);
a main circuit, wherein a bus capacitor (15) is connected between a positive electrode and a negative electrode of a battery side of the main circuit, and the bus capacitor (15) is connected to a power input end of the first SPS (11) a processor (13), wherein the processor (13) is communicatively connected to the DSP (12) and the battery management system, BMS, (16) and the processor (13) is configured to control a first preset power supply through the BMS (16) to supply power to the first SPS (11);
an alternating current pre-charge power supply (14), wherein an output end of the alternating current pre-charge power supply (14) is connected to the bus capacitor (15), and the alternating current pre-charge power supply (14) is configured to be controlled by the processor (13); wherein the processor (13) is configured to perform the fault detection method for a power conversion system according to any one of claims 1 to 8, to implement fault detection on the power conversion system.

10. The power conversion system according to claim 9, wherein the BMS (16) is configured to be powered by an external second SPS and configured to supply power to the processor (13).

11. The power conversion system according to claim 9, wherein
a positive electrode of the bus capacitor (15) is connected to a positive electrode of the input end of the first SPS (11) through a first diode (D1); and
the first preset power supply is configured to supply power to the first SPS (11) through a second diode (D2).

12. The power conversion system according to claim 9, wherein
a negative electrode of the input end of the first SPS (11) is connected to a negative electrode of the output end of the alternating current pre-charge power supply (14) through a third diode (D3); and
a negative electrode of the bus capacitor (15) is connected to the negative electrode of the output end of the alternating current pre-charge power supply (14) through a fourth diode (D4).

## Patentansprüche

1. Verfahren zur Fehlererkennung für ein Stromumwandlungssystem, umfassend:
Steuern (401, 503) einer Wechselstrom-Vorlade-Stromversorgung zum Betrieb, wenn das Stromumwandlungssystem in einem Blindleistungsmodus
arbeitet, um einen Buskondensator zu laden, der mit einem Gleichstrombus des Stromumwandlungssystems verbunden ist, wobei der Buskondensator dazu eingerichtet ist, einen digitalen Signalprozessor, DSP, über ein erstes Schaltnetzteil, SPS, mit Strom zu versorgen;
Bestimmen (402, 504), ob der DSP mit Strom versorgt wird, um ein erstes Bestimmungsergebnis zu erhalten;
Steuern (403, 505) einer ersten voreingestellten Stromversorgung zur Versorgung des DSP über das erste SPS mit Strom, wenn das erste Bestimmungsergebnis anzeigt, dass der DSP stromlos ist;
erneutes Bestimmen (404, 506), ob der DSP mit Strom versorgt wird, um ein zweites Bestimmungsergebnis zu erhalten;
Steuern (405, 507) einer zweiten voreingestellten Stromversorgung zum Laden des Buskondensators, wenn das zweite Bestimmungsergebnis anzeigt, dass der DSP mit Strom versorgt wird;
Bestimmen (407, 509), ob auf dem Gleichstrombus eine Spannung vorhanden ist, um ein drittes Bestimmungsergebnis zu erhalten; und
Bestimmen (408, 510), dass der Buskondensator kurzgeschlossen ist, wenn das dritte Bestimmungsergebnis anzeigt, dass auf dem Gleichstrombus keine Spannung vorhanden ist.

2. Verfahren zur Fehlererkennung für ein Stromumwandlungssystem nach Anspruch 1, ferner umfassend:
Bestimmen (406, 508), dass das erste SPS fehlerhaft ist, wenn das zweite Bestimmungsergebnis anzeigt, dass das DSP stromlos ist.

3. Verfahren zur Fehlererkennung für ein Stromumwandlungssystem nach Anspruch 1, ferner umfassend:
Bestimmen (409, 511), dass die Wechselstrom-Vorlade-Stromversorgung fehlerhaft ist, wenn das dritte Bestimmungsergebnis anzeigt, dass auf dem Gleichstrombus eine Spannung vorhanden ist.

4. Verfahren zur Fehlererkennung für ein Stromumwandlungssystem nach einem der Ansprüche 1 bis 3, wobei das Verfahren vor dem Steuern einer Wechselstrom-Vorlade-Stromversorgung zum Betrieb ferner umfasst:
Bestimmen (501), ob ein Prozessor des Stromumwandlungssystems kommunikativ mit einem Batteriemanagementsystem, BMS, verbunden ist; und
Steuern (503) der Wechselstrom-Vorlade-Stromversorgung zum Betrieb, falls bestimmt wird, dass der Prozessor kommunikativ mit dem BMS verbunden ist.

5. Verfahren zur Fehlererkennung für ein Stromumwandlungssystem nach Anspruch 4, wobei das Verfahren nach dem Bestimmen, ob ein Prozessor des Stromumwandlungssystems kommunikativ mit einem BMS verbunden ist, ferner umfasst:
Bestimmen (502), dass ein Kommunikationsfehler zwischen dem Prozessor und dem BMS vorliegt, falls bestimmt wird, dass der Prozessor nicht kommunikativ mit dem BMS verbunden werden kann.

6. Verfahren zur Fehlererkennung für ein Stromumwandlungssystem nach einem der Ansprüche 1 bis 3, wobei das Bestimmen, ob der DSP mit Strom versorgt wird, umfasst:
Bestimmen, ob der DSP kommunikativ mit einem Prozessor des Stromumwandlungssystems verbunden ist;
Bestimmen, dass der DSP mit Strom versorgt wird, falls bestimmt wird, dass der DSP kommunikativ mit dem Prozessor des Stromumwandlungssystems verbunden ist; und
Bestimmen, dass der DSP stromlos ist, falls bestimmt wird, dass der DSP nicht kommunikativ mit dem Prozessor des Stromumwandlungssystems verbunden werden kann.

7. Fehlerschutzverfahren für ein Stromumwandlungssystem, umfassend:
Steuern der Wechselstrom-Vorlade-Stromversorgung zum Stoppen des Betriebs, während der Fehlererkennung am Stromumwandlungssystem mit dem Verfahren zur Fehlererkennung für ein Stromumwandlungssystem nach einem der Ansprüche 1 bis 6, wenn bestimmt wird, dass der DSP zum ersten Mal stromlos ist.

8. Fehlerschutzverfahren für ein Stromumwandlungssystem nach Anspruch 7, ferner umfassend:
Steuern des Stromumwandlungssystems zum Stoppen des Betriebs, wenn bestimmt wird, dass der Buskondensator des Stromumwandlungssystems kurzgeschlossen ist, wenn bestimmt wird, dass die Wechselstrom-Vorlade-Stromversorgung fehlerhaft ist, oder wenn bestimmt wird, dass das erste SPS fehlerhaft ist.

9. Stromumwandlungssystem, umfassend:
einen digitalen Signalprozessor, DSP (12);
ein erstes Schaltnetzteil, SPS, (11), das dazu eingerichtet ist, den DSP (12) mit Strom zu versorgen;
ein Batteriemanagementsystem, BMS (16);
einen Hauptstromkreis, wobei ein Buskondensator (15) zwischen einer positiven Elektrode und einer negativen Elektrode einer Batterieseite des Hauptstromkreises verbunden ist, und der Buskondensator (15) mit einem Stromeingangsende des ersten SPS (11) verbunden ist,
einen Prozessor (13), wobei der Prozessor (13) kommunikativ mit dem DSP (12) und dem Batteriemanagementsystem, BMS, (16) verbunden ist und der Prozessor (13) dazu eingerichtet ist, eine erste voreingestellte Stromversorgung über das BMS (16) zu steuern, um das erste SPS (11) mit Strom zu versorgen;
eine Wechselstrom-Vorlade-Stromversorgung (14), wobei ein Ausgangsende der Wechselstrom-Vorlade-Stromversorgung (14) mit dem Buskondensator (15) verbunden ist und die Wechselstrom-Vorlade-Stromversorgung (14) dazu eingerichtet ist, durch den Prozessor (13) gesteuert zu werden;
wobei der Prozessor (13) dazu eingerichtet ist, das Verfahren zur Fehlererkennung für ein Stromumwandlungssystem nach einem der Ansprüche 1 bis 8 auszuführen, um eine Fehlererkennung am Stromumwandlungssystem zu implementieren.

10. Stromumwandlungssystem nach Anspruch 9, wobei das BMS (16) dazu eingerichtet ist, durch ein externes zweites SPS mit Strom versorgt zu werden, und dazu eingerichtet ist, den Prozessor (13) mit Strom zu versorgen.

11. Stromumwandlungssystem nach Anspruch 9, wobei eine positive Elektrode des Buskondensators (15) über eine erste Diode (D1) mit einer positiven Elektrode des Eingangsendes des ersten SPS (11) verbunden ist; und
die erste voreingestellte Stromversorgung dazu eingerichtet ist, das erste SPS (11) über eine zweite Diode (D2) mit Strom zu versorgen.

12. Stromumwandlungssystem nach Anspruch 9, wobei eine negative Elektrode des Eingangsendes des ersten SPS (11) über eine dritte Diode (D3) mit einer negativen Elektrode des Ausgangsendes der Wechselstrom-Vorlade-Stromversorgung (14) verbunden ist; und
eine negative Elektrode des Buskondensators (15) über eine vierte Diode (D4) mit der negativen Elektrode des Ausgangsendes der Wechselstrom-Vorlade-Stromversorgung (14) verbunden ist.

## Revendications

1. Procédé de détection de défaillance pour un système de conversion de puissance, comprenant :
la commande (401, 503), lorsque le système de conversion de puissance fonctionne dans un mode réactif,
du fonctionnement d'une alimentation électrique de précharge en courant alternatif pour charger un condensateur de bus relié à un bus en courant continu du système de conversion de puissance, dans lequel le condensateur de bus est configuré pour alimenter un processeur de signal numérique, DSP, par l'intermédiaire d'une première alimentation électrique à découpage, SPS ;
la détermination (402, 504) de si le DSP est sous tension pour obtenir un premier résultat de détermination ;
la commande (403, 505) d'une première alimentation électrique prédéfinie pour alimenter le DSP par l'intermédiaire de la première SPS, si le premier résultat de détermination indique que le DSP est hors tension ;
la redétermination (404, 506) de si le DSP est sous tension pour obtenir un deuxième résultat de détermination ;
la commande (405, 507) d'une deuxième alimentation électrique prédéfinie pour charger le condensateur de bus, si le deuxième résultat de détermination indique que le DSP est sous tension ;
la détermination (407, 509) de si une tension est présente sur le bus en courant continu pour obtenir un troisième résultat de détermination ; et
la détermination (408, 510) que le condensateur de bus est en court-circuit, si le troisième résultat de détermination indique qu'aucune tension n'est présente sur le bus en courant continu.

2. Procédé de détection de défaillance pour un système de conversion de puissance selon la revendication 1, comprenant en outre :
la détermination (406, 508) que la première SPS est défaillante, si le deuxième résultat de détermination indique que le DSP est hors tension.

3. Procédé de détection de défaillance pour un système de conversion de puissance selon la revendication 1, comprenant en outre :
la détermination (409, 511) que l'alimentation électrique de précharge en courant alternatif est défaillante, si le troisième résultat de détermination indique qu'une tension est présente sur le bus en courant continu.

4. Procédé de détection de défaillance pour un système de conversion de puissance selon l'une quelconque des revendications 1 à 3, dans lequel avant la commande du fonctionnement d'une alimentation électrique de précharge en courant alternatif, le procédé comprend en outre :
la détermination (501) de si un processeur du système de conversion de puissance est relié de manière communicative à un système de gestion de batterie, BMS ; et
la commande (503) du fonctionnement de l'alimentation électrique de précharge en courant alternatif, dans un cas de détermination que le processeur est relié de manière communicative au BMS.

5. Procédé de détection de défaillance pour un système de conversion de puissance selon la revendication 4, dans lequel après la détermination de si un processeur du système de conversion de puissance est relié de manière communicative à un BMS, le procédé comprend en outre :
la détermination (502) qu'il y a une défaillance de communication entre le processeur et le BMS, dans un cas de détermination que le processeur ne parvient pas à être relié de manière communicative au BMS.

6. Procédé de détection de défaillance pour un système de conversion de puissance selon l'une quelconque des revendications 1 à 3, dans lequel la détermination de si le DSP est sous tension comprend :
la détermination de si le DSP est relié de manière communicative à un processeur du système de conversion de puissance ;
la détermination que le DSP est sous tension, dans un cas de détermination que le DSP est relié de manière communicative au processeur du système de conversion de puissance ; et
la détermination que le DSP est hors tension, dans un cas de détermination que le DSP ne parvient pas à être relié de manière communicative au processeur du système de conversion de puissance.

7. Procédé de protection de défaillance pour un système de conversion de puissance, comprenant :
la commande, pendant une détection de défaillance sur le système de conversion de puissance avec le procédé de détection de défaillance pour un système de conversion de puissance selon l'une quelconque des revendications 1 à 6, de l'arrêt du fonctionnement de l'alimentation électrique de précharge en courant alternatif lorsqu'il est déterminé que le DSP est hors tension pour une première fois.

8. Procédé de protection de défaillance pour un système de conversion de puissance selon la revendication 7, comprenant en outre :
la commande de l'arrêt du fonctionnement du système de conversion de puissance lorsqu'il est déterminé que le condensateur de bus du système de conversion de puissance est en court-circuit, lorsqu'il est déterminé que l'alimentation électrique de précharge en courant alternatif est défaillante, ou lorsqu'il est déterminé que la première SPS est défaillante.

9. Système de conversion de puissance, comprenant :
un processeur de signal numérique, DSP (12) ;
une première alimentation électrique à découpage, SPS, (11) configurée pour alimenter le DSP (12) ; un système de gestion de batterie, BMS (16) ;
un circuit principal, dans lequel un condensateur de bus (15) est relié entre une électrode positive et une électrode négative d'un côté batterie du circuit principal, et le condensateur de bus (15) est relié à une extrémité d'entrée de puissance de la première SPS (11) ;
un processeur (13), dans lequel le processeur (13) est relié de manière communicative au DSP (12) et au système de gestion de batterie, BMS, (16) et le processeur (13) est configuré pour commander une première alimentation électrique prédéfinie par l'intermédiaire du BMS (16) pour alimenter la première SPS (11) ;
une alimentation électrique de précharge en courant alternatif (14), dans lequel une extrémité de sortie de l'alimentation électrique de précharge en courant alternatif (14) est reliée au condensateur de bus (15), et l'alimentation électrique de précharge en courant alternatif (14) est configurée pour être commandée par le processeur (13) ;
dans lequel le processeur (13) est configuré pour réaliser le procédé de détection de défaillance pour un système de conversion de puissance selon l'une quelconque des revendications 1 à 8, pour mettre en œuvre une détection de défaillance sur le système de conversion de puissance.

10. Système de conversion de puissance selon la revendication 9, dans lequel le BMS (16) est configuré pour être alimenté par une deuxième SPS externe et configuré pour alimenter le processeur (13).

11. Système de conversion de puissance selon la revendication 9, dans lequel une électrode positive du condensateur de bus (15) est reliée à l'électrode positive de l'extrémité d'entrée de la première SPS (11) par l'intermédiaire d'une première diode (D1) ; et
la première alimentation électrique prédéfinie est configurée pour alimenter la première SPS (11) par l'intermédiaire d'une deuxième diode (D2).

12. Système de conversion de puissance selon la revendication 9, dans lequel une électrode négative de l'extrémité d'entrée de la première SPS (11) est reliée à l'électrode négative de l'extrémité de sortie de l'alimentation électrique de précharge en courant alternatif (14) par l'intermédiaire d'une troisième diode (D3) ; et
une électrode négative du condensateur de bus (15) est reliée à l'électrode négative de l'extrémité de sortie de l'alimentation électrique de précharge en courant alternatif (14) par l'intermédiaire d'une quatrième diode (D4).
